# EUROPÄISCHE PATENTANMELDUNG

(11) **EP 0 703 673 A2**
(43) Veröffentlichungstag der Anmeldung: **27.03.1996**
(21) Anmeldenummer: 95113135.8
(22) Anmeldetag: 22.08.1995
(51) Int. Cl.: H03L 7/081, H03K 5/13

(54) **Vorrichtung zum Abgeben von mehreren gleichen, gegeneinander phasenverschobenen, periodischen Signalen**

(30) Priorität: 26.08.1994 CH 2617/94
(71) Anmelder: ASCOM TECH AG, CH-3018 Bern (CH)
(72) Erfinder: Beeler, Daniel, CH-8725 Gebertingen (CH)
(74) Vertreter: Schwerdtel, Eberhard, Dr.

(57) **Zusammenfassung**

Die Vorrichtung (10) besitzt einen Signaleingang (20), einen Kontrolleingang (26) und acht Signalausgänge (32-39). Sie umfasst acht in Reihe geschaltete, bevorzugt gleiche Verzögerungselemente (12-19), einen Phasenvergleicher (25) und ein Filter (27). Der Eingang des ersten (12) und der Ausgang des letzten Verzögerungselementes (19) sind mit zwei Eingängen (24, 23) des Phasenvergleichers (25) verbunden. Der Ausgang des Phasenvergleichers ist über das Filter (27) parallel mit dem Steuereingang (11) jedes der Verzögerungselemente (12-19) verbunden. Hierdurch ist ein geschlossener Regelkreis gebildet, der ausgebildet ist zum Einregeln auf eine vorgegebene Gesamtverzögerung aller Verzögerungselemente (12-19). Der innere Aufbau des Phasenvergleichers (25) ist besonders einfach, wenn die Gesamtverzögerung der Phasenlänge des periodischen Signals (E) am Signaleingang (20) entspricht. Ein Kontrollsignal (K) am Kontrolleingang (26) verhindert, dass ein Einregeln bei einer Harmonischen dieser Phasenlänge erfolgt. Die periodischen, gestuft verzögerten, ansonsten gleichen Ausgangssignale (A1-A8) sind an den parallelen Ausgängen (32-39) abgreifbar.

## Beschreibung

Die Erfindung betrifft eine Vorrichtung zum Abgeben von mehreren gleichen, periodischen Signalen, die gegeneinander phasenverschoben sind entsprechend dem Oberbegriff von Anspruch 1.

Aus der Schrift US Re. 32,945 ist eine Vorrichtung zum Ermitteln einer optimalen Abtastphase für digitale Daten bekannt, die mit einem bekannten Takt und mit unbekannter Phase empfangen werden. Diese Vorrichtung weist eine Kette aus sieben Verzögerungselementen auf, die ein Taktsignal schrittweise verzögert. Hierbei erscheinen an acht parallelen Ausgängen gleichmässig über die Periode des ursprünglichen Taktsignals verteilte, ansonsten gleiche Taktignale. Diese gegeneinander und stufenweise phasenverzögerten Taktsignale dienen zum parallelen Abtasten der Daten, wodurch sich die optimale Abtastphase zum nachfolgenden Regenerieren des Datensignals ermitteln lässt.

Die genannte, beispielsweise Schrift gibt nicht an, wie die genannten Verzögerungselemente aufgebaut sind und wie die gleichmässige Verteilung über die Taktperiode erreicht wird. Es besteht daher die Aufgabe, eine preiswerte Vorrichtung anzugeben, die der genannten Kette aus sieben Verzögerungselementen entspricht, wobei diese Vorrichtung mikroelektronisch integrierbar sein und bezüglich des Verzögerungswertes unkritisch veränderbar sein soll.

Die Lösung dieser Aufgabe ist durch den kennzeichnenden Teil von Anspruch 1 gegeben. Die abhängigen Ansprüche geben Ausgestaltungen der Erfindung an.

Im folgenden wird die Erfindung anhand von drei Figuren beispielsweise näher beschrieben. Es zeigen:
Fig. 1 - Blockschaltbild eines Verzögerungsschaltkreises,
Fig. 2 - Schaltung eines Verzögerungselementes,
Fig 3 - Periodisches Signal.

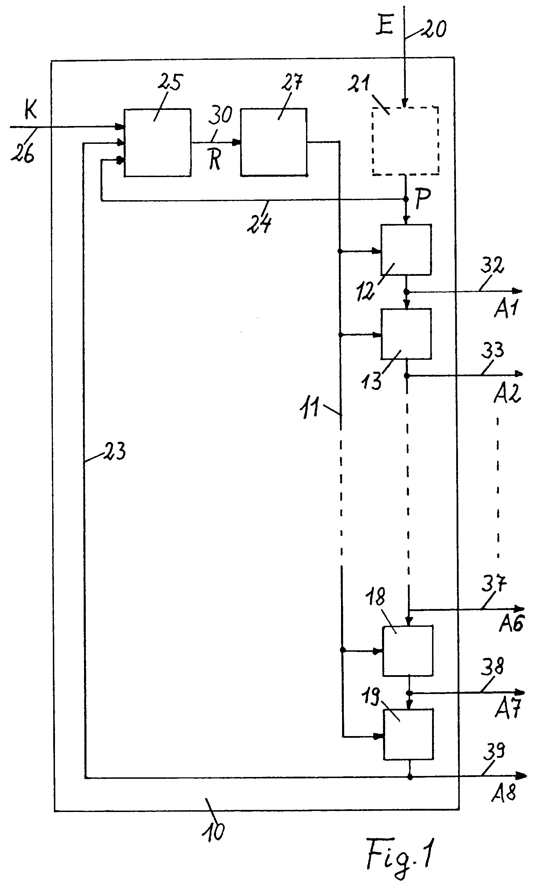

Fig. 1 zeigt das Blockschaltbild eines Verzögerungsschaltkreises 10. Diese Schaltung 10 weist n Verzögerungselemente 12-19 auf, wobei die Zahl n beispielsweise acht ist. (Die Elemente 14-17 sind nur andeutungsweise gezeigt). Die Schaltung 10 weist weiter einen Signalformer 21, einen Phasenvergleicher 25 und ein Filter 27 auf. Der Schaltkreis 10 weist schliesslich einen Eingang 20 zum Eingeben eines ursprünglichen, periodischen Signals E, einen Kontrolleingang 26 und n parallele Signalausgänge 32-39 für die Ausgangssignale A1-A8 auf.

Die Verzögerungselemente 12-19 besitzen jeweils einen Signaleingang, einen Signalausgang und einen Steuereingang 11. Wie Fig. 1 zeigt, sind die Verzögerungselemente 12-19 über ihre Signalein- und -ausgänge untereinander und mit dem Signalformer 21 in Serie geschaltet. Dies bedeutet, das erste Verzögerungselement 12 ist mit seinem Signaleingang mit dem Ausgang 24 des Signalformers 21 verbunden, das Verzögerungselement 13 ist mit seinem Signaleingang mit dem Ausgang des Verzögerungselements 12 verbunden, usw. Die Verbindungen zwischen den Verzögerungselementen 12-19 und der Ausgang des Verzögerungselements 19 bilden die genannten Signalausgänge 32-39.

Der Ausgang 24 des Signalformers 21 ist weiter mit dem einen der beiden Signaleingänge des Phasenvergleichers 25 verbunden, der Ausgang des letzten Verzögerungselementes 19 mit dem anderen 23 der Signaleingänge. Die Steuereingänge 11 aller Verzögerungselemente 12-19 sind parallel zueinander und über das Filter 27 mit dem Ausgang 30 des Phasenvergleichers 25 verbunden. Der genannte Kontrolleingang 26 des Verzögerungsschaltkreises 10 bildet einen dritten Eingang 22 des Phasenvergleichers 25.

Der Verzögerungsschaltkreis 10 bildet einen geschlossenen Regelkreis. Dieser regelt sich so ein, dass die Phasendifferenz zwischen den periodischen Signalen P und A8 an den beiden Signaleingängen 23, 24 des Phasenvergleichers 25 einem vorbestimmten Wert entspricht. Diese Phasendifferenz ist bevorzugt gleich Null, was für den Phasenvergleicher 25 gleich ist mit 2π bzw. der Länge T einer Periode der periodischen Signale A1-A8.

Im Regelkreis gibt der Phasenvergleicher 25 über seinen Ausgang 30 ein Regelsignal R an die Steuereingänge 11 ab, bevorzugt einen Steuerstrom. Dieser Steuerstrom verändert die Verzögerungszeiten aller Verzögerungselemente 12-19 in der Weise, dass schliesslich die Gesamtverzögerung der Verzögerungskette dem genannten vorbestimmten Wert der Phasendifferenz entspricht, d.h. im bevorzugten Fall gleich der Periodendauer des am Signaleingang 20 anliegenden Signals E bzw. des Signals P am Eingang 29 der Verzögerungskette ist.

Im eingeregelten Fall und bei Verwendung von n gleichen Verzögerungselementen 12-19 verzögert jedes dieser Elemente das am Eingang 29 des ersten Verzögerungselementes 12 anliegende periodische Signal P um 1/n der gewünschten Phasendifferenz, im bevorzugten Fall von n = 8 um 1/8 der Periodenlänge T. Die stufenweise verzögerten Ausgangssignale A1 bis A8 sind dabei an den Ausgängen 32-39 abgreifbar.

Der dritte Eingang 26 des Phasenvergleichers 25 dient zum Eingeben eines Kontrollsignals K. Dieses Signal K verhindert, dass der Vergleicher 25 bei einer Harmonischen des genannten Wertes 2π einregelt, d.h. beispielsweise bei 4π.

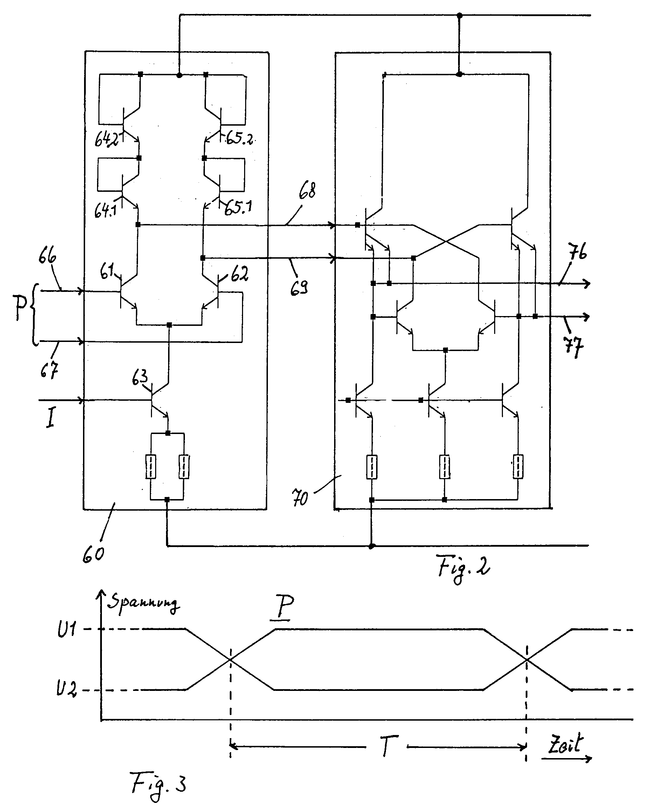

Fig. 2 zeigt das detaillierte Schaltbild eines Verzögerungselementes 12-19. Dieses Element besteht im wesentlichen aus zwei Blöcken, d.h. einem Delay 60 und einem diesem nachgeschalteten Komparator 70. Das Delay 60 bildet eine Art von Differenzverstärker mit zwei Eingangstransistoren 61, 62, die an eine gemeinsame Stromquelle angeschlossen sind. Diese Stromquelle wird im wesentlichen durch einen Transistor 63 gebildet, dessen Emitter/Kollektor-Strom über seine Basis steuerbar ist. Die Kollektorwiderstände der beiden Transistoren 61, 62 werden durch je zwei in Serie geschaltete Dioden 64.1, 64.2 bzw. 65.1, 65.2 gebildet, deren Innenwiderstand vom jeweils durchfliessenden Strom abhängig ist.

Wechselt die Polarität des Eingangssignals P, dann verhalten sich die Dioden 64.1, 64.2, 65.1, 65.2 wie RC-Glieder, wobei die jeweilige Kapazität C durch die Sperrschichten der Transistor-Kollektoren und der Dioden gebildet wird. Die benötigte Zeit für das Umladen der RC-Glieder hängt daher entscheidend vom jeweiligen Wert der Innenwiderstände der Dioden 64.1, 64.2, 65.1 und 65.2 ab, die - wie beschrieben - durch den steuerbaren Ausgangsstrom der genannten Stromquelle variiert werden können. Auf diese Weise ergibt sich bei einem geeigneten, periodischen Eingangssignal P ein jeweils mehr oder weniger zeitverschobenes, invertiertes und ansonsten unverändertes Ausgangssignal an den Signalausgängen 68, 69. Dies bedeutet, es ergibt sich - wie verlangt - eine elektrisch steuerbare Verzögerung des periodischen Signals P.

Der Komparator 70 dient vor allem als Treiberschaltung zum Formen eines genügend leistungsstarken bzw.niederohmigen Ausgangssignals A1 bzw. A2, A3 usw. an seinen Ausgängen 76, 77. Er dient weiter zum Normieren seines Ausganssignals als jeweiliges Eingangssignal für die nächste Verzögerungsstufe. Damit trägt der Komparator 70 zur eigentlichen Verzögerung des periodischen Signals P nichts bei, sondern erfüllt im wesentlichen die Funktion eines Emitterfolgers.

Fig. 3 zeigt das bevorzugte periodische Signal P. Dieses Signal P setzt sich aus zwei gegenläufigen, trapezförmigen, sich periodisch kreuzenden Spannungswerten U1, U2 zusammen.

Der Abstand zwischen jeweils zwei Kreuzungspunkten im Bereich der im wesentlichen linearen Flanken bildet die Periodenlänge T des Signals P. Die Kreuzungspunkte sind einfach und exakt ermittelbar, was von genereller Bedeutung ist, z.B. beim Synchronisieren auf das Signal P.

Der Signalformer 21 von Fig. 1 hat die Aufgabe, aus einem im Grunde beliebigen, periodischen Ursprungssignal E das anhand von Fig. 3 beschriebene Signal P zu bilden. Der Signalformer 21 kann hierzu als Signalwandler ausgebildet sein, aber auch als eigenständiger Taktgenerator, der das Signal E selbst generiert.

Das Filter 27 von Fig. 1 hat die Aufgabe, das Regelsignal R zum Steuern der Verzögerungselemente 12-19 zu glätten. Wie beschrieben, ist das Signal R bevorzugt ein Gleichstrom. Damit ist die Ausbildung des Filters bevorzugt ein einfaches Siebglied für diesen Strom.

Die Schaltung der Verzögerungselemente 12-19 entsprechend Fig. 2 lässt sich relativ problemlos mikroelektronisch integrieren. Dies erlaubt den Aufbau des Verzögerungsschaltkreises 10 auf einem einzigen Chip, was aus Preisgründen sehr wesentlich ist.

Die Erfindung lässt sich auf mannigfaltige Art variieren. Nachfolgend werden einige dieser Varianten genannt:
- Es kann auf das Filter 27 verzichtet werden, wenn das vom Phasenvergleicher 25 abgegebene Regelsignal R genügend rauscharm ist.
- Die Zahl n der Verzögerungselemente 12-19 kann grösser oder kleiner als acht sein. Die Zahl n der Verzögerungselemente 12-19 kann grösser oder gleich der Zahl von Ausgängen 32-39 sein.
- Die Verzögerungselemente 13-19 können alle gleich sein und stets einen etwa gleichen Verzögerungswert zur Gesamtverzögerung des Verzögerungsschaltkreises 10 beitragen. Sie können aber auch unterschiedlich sein, so dass sich von Verzögerungselement zu Verzögerungselement unterschiedliche, vorbestimmte Phasenverzögerungen ergeben.
- Es können alle Verzögerungselemente 13-19 elektrisch steuerbar sein. Es ist jedoch auch möglich, in der Kette der Verzögerungselemente mehrere auf einen konstanten Verzögerungswert fixierte Verzögerungselemente vorzusehen. Oder es können Verzögerungselemente vorgesehen werden, die anders als die anderen Verzögerungselemente auf den Steuerstrom R reagieren, z.B. stärker.
- Der Verzögerungsschaltkreis 10 kann sich im Grunde auf jede gewünschte Phasendifferenz einregeln. Entspricht die gewünschte Phasendifferenz der Periodenlänge T, dann müssen im Phasenvergleicher 25 nur die formgleichen Signale P und A8 zur Deckung gebracht werden, was einen besonders einfachen Aufbau der Einheit 25 erlaubt.
- Die Ausgänge 32-39 können den Verzögerungselementen 12-19 anders zugeordnet werden, als dies in Fig. 1 gezeigt ist. Dies bedeutet, dass der Ausgang mit der niedrigsten Bezugszeichen-Nummer (32) an den Ausgang 29 des Signalformers 21 angeschlossen wird und der Ausgang mit der höchsten Bezugszeichen-Nummer (39) an die Verbindung zwischen dem Ausgang des vorletzten Verzögerungselementes 18 und dem Eingang des letzten Verzögerungselementes 19.

## Patentansprüche

1. Vorrichtung mit einer Mehrzahl n paralleler Ausgänge (32-39) zum Abgeben einer entsprechenden Anzahl gleicher periodischer Signale (A1-A8), die gegeneinander in vorbestimmter Weise phasenverschoben sind,
wobei ein Signaleingang und in Reihe geschaltete, mit den Ausgängen (32-39) verbundene Verzögerungselemente (12-19) vorgesehen sind,
dadurch gekennzeichnet,
- dass wenigstens eine der Mehrzahl n entsprechende Anzahl von Verzögerungselementen (12-19) vorgesehen ist,
- dass die Verzögerungselemente (12-19) wenigstens teilweise als Elemente mit elektrisch steuerbarer Verzögerungszeit ausgebildet sind,
- dass das erste (32) und das letzte Verzögerungselement (19) mit zwei Signaleingängen (23, 24) eines Phasenvergleichers (25) verbunden sind, und
- dass der Ausgang des Phasenvergleichers (25) mit den Steuereingängen (11) der elektrisch steuerbaren Verzögerungselemente (12-19) verbunden ist,
insgesamt derart, dass die Vorrichtung einen geschlossenen Regelkreis bildet, der ausgebildet ist zum Einregeln auf eine vorgegebene Gesamtverzögerung der Verzögerungselemente (12-19).

2. Vorrichtung nach Anspruch 1,
dadurch gekennzeichnet,
- dass alle Verzögerungselemente (13-19) elektrisch steuerbar und gleich sind, und
- dass der Phasenvergleicher (25) ausgebildet ist zum Einregeln auf eine Gesamtverzögerung der Verzögerungselemente (12-19), die der Phasenlänge (T) der periodischen Signale entspricht.

3. Vorrichtung nach Anspruch 1,
dadurch gekennzeichnet,
dass die Anzahl der Verzögerungselemente (13-19) acht ist.

4. Vorrichtung nach Anspruch 1,
dadurch gekennzeichnet,
dass ein Signalformer (21) vorgesehen ist, der mit seinem Ausgang (29) an das erste Verzögerungselement (12) angeschlossen und so ausgebildet ist, dass er (21) ein an seinem Eingang (20) anliegendes Periodensignal (E) in das periodische Signal (P) umwandelt.

5. Vorrichtung nach Anspruch 1,
dadurch gekennzeichnet,
dass jedes elektrisch steuerbare Verzögerungselement (13-19) einen Delay-Block (60) umfasst, der im wesentlichen einen Differenzverstärker bildet mit steuerbarer Stromquelle (78) und mit Kollektorwiderständen aus Dioden (64.1, 64.2, 65.1, 65.2).

6. Vorrichtung nach Anspruch 5,
dadurch gekennzeichnet,
dass jedes elektrisch steuerbare Verzögerungselement (13-19) einen Komparator (70) umfasst, der dem Delay-Block (60) nachgeschaltet ist, und der aus dessen Ausgangssignal ein niederohmigeres Signal macht.

7. Vorrichtung nach Anspruch 1,
dadurch gekennzeichnet,
dass der Phasenvergleicher (25) einen weiteren Eingang (22) aufweist zum Eingeben eines Kontrollsignals (K) zum Verhindern eines fehlerhaften Einregelns des Regelkreises.

8. Vorrichtung nach Anspruch 1,
dadurch gekennzeichnet,
dass dem Phasenvergleicher (25) ein Filter (27) nachgeschaltet ist zum Glätten des vom Phasenvergleicher (25) abgegebenen Regelsignals (R).
